# EUROPÄISCHE PATENTANMELDUNG

(11) **EP 2 061 276 A1**
(43) Veröffentlichungstag der Anmeldung: **20.05.2009**
(21) Anmeldenummer: 08165454.3
(22) Anmeldetag: 30.09.2008
(51) Int. Cl.: H04R 25/00

(54) **Hörhilfegerät**

(30) Priorität: 14.11.2007 DE 102007054325
(71) Anmelder: Siemens Medical Instruments Pte. Ltd., Singapore 139959 (SG)
(72) Erfinder: Leong, Chee Wah, 650616 Singapore (SG)
(74) Vertreter: Maier, Daniel Oliver

(57) **Zusammenfassung**

Hörhilfegerät mit einem Gehäuse (1), darin angeordneten elektrischen Bauteilen und einem Stellelement (10), das vorgesehen ist, einen Einstellwert der elektrischen Bauteile zu verändern, wobei das Stellelement (10) berührungsfrei bedienbar ist.

## Beschreibung

Die Erfindung betrifft ein Hörhilfegerät mit einem Gehäuse und darin angeordneten elektrischen Bauteile.

Hörhilfegeräte dienen dazu, Hörverluste bei Schwerhörigen auszugleichen. Es sind sogenannte Hinter-dem-Ohr-Geräte bekannt, die aus einer im Ohr getragenen Otoplastik, sowie aus einem hinter dem Ohr getragenen Gehäuse bestehen, welches die zur Realisierung einerHörhilfefunktion notwendigen elektrischen Bauteile enthält. Weiter sind Im-Ohr-Geräte bekannt, die lediglich aus einem im Ohr getragenen Teil bestehen, der die elektrischen Bauteile enthält.

Bekannte Hörhilfegeräte weisen Taster, Schalter, Schieberegler und dergleichen auf, mit denen das Hörhilfegerät ein- bzw. ausgeschaltet werden kann, mit denen die Lautstärke des Hörhilfegeräts verändert werden kann, und die zur Anpassung weiterer Einstellwerte des Hörhilfegeräts vorgesehen sind. Ein Problem solcher mechanischen Schalt- und Stellelemente ist ihre Störanfälligkeit und Empfindlichkeit gegenüber Abnutzungs- und Verschmutzungserscheinungen.

Aus der Druckschrift DE 196 33 321 A1 ist ein Hörhilfegerät mit einem externen Stellglied zum Steuern eines Betriebsmodus bekannt. Das Stellglied umfasst einen Schwenkhebel, der endseitig einen Magneten aufweist, und auf dessen Magnetfeld ein im Inneren des Gehäuses des Hörhilfegeräts vorgesehenes Sensorelement reagiert. Das Sensorelement wird mithin berührungslos aktiviert, der Schwenkhebel selbst wird jedoch mechanisch betätigt.

Aus der Druckschrift EP 0 548 379 B1 ist ein Hörhilfegerät mit einem Gehäuse und darin angeordneten elektrischen Bauelementen, wie Mikrofon, Verstärker, Hörer, Stromquelle, Ein-/Ausschalter und Stellelementen bekannt, bei dem die Verwendung von Druck- und Positionssensoren in Filmauslegung vorgesehen ist. Die Druck- und Positionssensoren bestehen aus zusammenlaminierten Polymerlagen, wobei eine Lage mit interdigitierenden Elektroden und die zugehörige andere Lage mit einem Halbleitermaterial beschichtet ist, wobei die Sensoren auf der Außenseite und/oder auf der Innenseite des Gehäuses und/oder in der Gehäusewandung und/oder an einem im Gehäuse befindlichem Träger angeordnet sind. Die Sensoren reagieren auf Berührung oder Druck mit variablem elektrischen Widerstand. Die Sensoren sind als Schalter und/oder als Regler ausgebildet. Sie lassen sich nicht berührungsfrei bedienen. Ein Nachteil dieses Hörhilfegeräts ist die ebenfalls durch Abnutzungserscheinungen zunehmende Störanfälligkeit der als Stell-, Regel- oder Schaltelemente vorgesehenen Druck- und Positionssensoren.

Aufgabe der Erfindung ist es, ein Hörhilfegerät der eingangs genannten Art bezüglich der Schalt-, Stell- und/oder Regelelemente nach Aufbau und Bedienung vorteilhafter auszubilden, derart, dass bedienungsfreundliche, dauerhafte, wenig störanfällige und miniaturisierbare Bauelemente zum Einsatz kommen.

Diese Aufgabe wird durch ein Hörhilfegerät gemäß Anspruch 1 gelöst. Bevorzugte Weiterbildungen sind in den abhängigen Unteransprüchen angegeben.

Das erfindungsgemäße Hörhilfegerät weist ein Gehäuse mit darin angeordneten elektrischen Bauteilenund ein Stellelement auf, das vorgesehen ist, einen Einstellwert der elektrischen Bauteile zu verändern, wobei das Stellelement berührungsfrei bedienbar ist.

Bei dem erfindungsgemäßen Hörhilfegerät sind einige oder alle mechanischen Stellelemente durch ein oder mehrere berührungslose Stellelemente ersetzt. Der Benutzer des erfindungsgemäßen Hörhilfegeräts kann durch Annähren eines Fingers oder Gegenstands an ein berührungsloses Stellelement des Hörhilfegeräts eine Einstellung des Hörhilfegeräts verändern. Beispielsweise kann das erfindungsgemäße Hörhilfegerät durch einmaliges Annähren eines Fingers oder Gegenstands an das Stellelement ein- bzw. ausgeschaltet werden. In einer anderen Ausführungsform kann das erfindungsgemäße Hörhilfegerät beispielsweise durch zweimaliges Annähren eines Fingers oder Gegenstands an das Stellelement innerhalb einer festgelegten Zeit ein- bzw. ausgeschaltet werden. Weiter kann der Benutzer beispielsweise die Lautstärke des Hörhilfegerätes anpassen, indem er mit einem Finger über ein Stellelement des Hörhilfegeräts streicht.

In einer bevorzugten Ausführungsform des erfindungsgemäßen Hörhilfegeräts ist das Stellelement ausgelegt, eine Mehrzahl von Bewegungsmustern des berührungsfrei detektierten Fingers oder Gegenstands zu unterscheiden und jeweils zugeordnete Einstellwerte des Hörhilfegeräts zu verändern.

Da das Stellelement des erfindungsgemäßen Hörhilfegeräts ohne mechanisch bewegliche Bauteile auskommt, ist es unempfindlich gegenüber Abnutzungserscheinungen.

In einer vorteilhaften Ausgestaltung der Erfindung sind die ein oder mehreren Stellelemente innerhalb des Gehäuses des Hörhilfegeräts vorgesehen. Dies erlaubt es, das Gehäuse mit einer glatten, durchgängig geschlossenen Oberfläche zu versehen. Dadurch kann das Hörhilfegerät gefälliger gestaltet und vom Benutzer unauffälliger getragen werden. Durch das geschlossene Gehäuse wird es weiter möglich, das Hörhilfegerät spritzwassergeschützt oder wasserdicht auszugestalten. Dadurch sinkt dessen Störanfälligkeit zusätzlich.

In einer bevorzugten Ausführungsform des erfindungsgemäßen Hörhilfegeräts ist das Stellelement ausgelegt, durch Messung einer elektrischen Kapazität die Anwesenheit und/oder Position eines Gegenstands oder Fingers in der Umgebung des Stellelements zu detektieren.

In einer weiteren bevorzugten Ausführungsform des erfindungsgemäßen Hörhilfegeräts ist das Stellelement ausgelegt, durch Messung des reflektierten Signals eines ausgesandten Messsignals die Anwesenheit und/oder Position eines Gegenstands oder Fingers in der Umgebung des Stellelements zu detektieren.

In einer weiteren bevorzugten Ausführungsform des erfindungsgemäßen Hörhilfegeräts ist das Stellelement ausgelegt, durch Messung einer Wärmestrahlung die Anwesenheit und/oder Position eines Gegenstands oder Fingers in der Umgebung des Stellelements zu detektieren.

Die Erfindung wird nachfolgend anhand der in den Zeichnungen dargestellten Ausführungsbeispiele weiter erläutert. Es zeigen:
Figur 1 ein gemäß der Erfindung ausgebildetes Hörhilfegerät mit einem Stellelement 10, wobei das Hörhilfegerät im Ausführungsbeispiel als ein hinter dem Ohr zu tragendes Hörhilfegerät gestaltet ist;
Figur 2 einen Schnitt durch ein Gehäuse 1 eines erfindungsgemäßen Hörhilfegeräts mit einem innerhalb des Gehäuses angebrachten Stellelement 10 und einem das Stellelement 10 überstreichenden Finger 20 des Benutzers;
Figur 3 einen Schnitt durch ein Gehäuse 1 eines erfindungsgemäßen Hörhilfegeräts mit einem in die Gehäusewand eingesetzten Stellelement 10 und einem das Stellelement 10 überstreichenden Finger 20 des Benutzers;
Figur 4 eine weitere schematische Ansicht eines erfindungsgemäßen Hörhilfegeräts mit einem Gehäuse 1 und einem darin mittels Führungsschienen 12 angebrachten Stellelement 10.

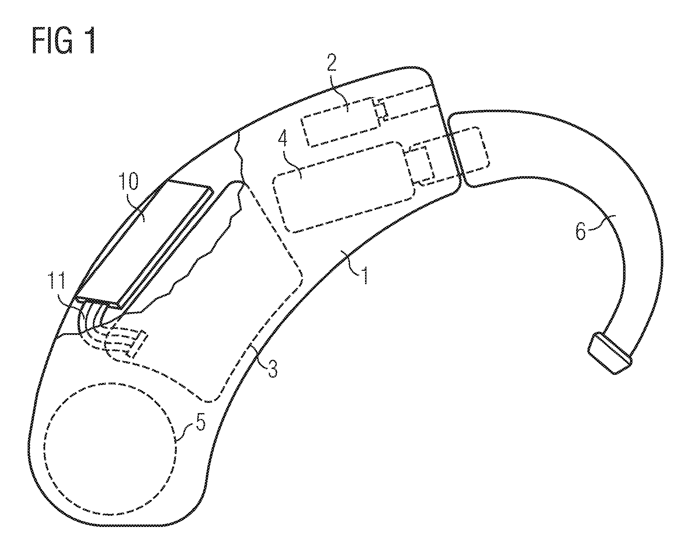

Figur 1 zeigt ein Gehäuse 1 eines hinter dem Ohr zu tragenden Hörhilfegeräts. Innerhalb des Gehäuses 1 ist eine Hörhilfefunktion realisiert. Die Realisierung der Hörhilfefunktion kann elektrische Bauteile, wie ein Mikrofon 2, einen Verstärker 3, einen Hörer 4, sowie eine Stromquelle 5 umfassen. Das Gehäuse 1 weist einen Traghaken 6 auf, der es erlaubt, das Gehäuse 1 des Hörhilfegeräts hinter dem Ohr zu befestigen. Das Hörhilfegerät nimmt mit Hilfe des Mikrofons 2 Umgebungsgeräusche auf, verstärkt diese mittels des Verstärkers 3 und gibt sie über den Hörer 4 wieder.

Weiter weist das Gehäuse 1 des Hörhilfegeräts ein Stellelement 10 auf. Das Stellelement 10 ist innerhalb des Gehäuses 1 parallel zu einer Oberfläche des Gehäuses 1 angeordnet. Das Stellelement 10 ist über ein flexibles Kabel 11 mit dem Verstärker 3 der Hörhilfefunktion verbunden.

Durch Antippen des Stellelements 10 mit einem Finger 20 kann das Hörhilfegerät ein- oder ausgeschaltet werden. Die Auswertelektronik des Stellelements 10 interpretiert eine kurze Berührung des Stellelements 10 als Wunsch des Benutzers, das Hörhilfegerät ein- bzw. auszuschalten. In einer alternativen Ausführungsform interpretiert die Auswertelektronik des Stellelements 10 eine zweimalige kurze Berührung des Stellelements 10 innerhalb einer festgelegten Zeit als Wunsch des Benutzers, das Hörhilfegerät ein- bzw. auszuschalten.

Der Benutzer des Hörhilfegeräts kann die eingestellte Lautstärke des Hörhilfegeräts verändern, indem er mit einem Finger 20 über die Oberfläche des Stellelements 10 streicht. Die Auswertelektronik des Stellelements 10 interpretiert eine streichende Bewegung des Fingers 20 in eine erste Richtung entlang der Oberfläche des Stellelements 10 als Wunsch, die eingestellte Lautstärke des Hörhilfegeräts zu erhöhen. Die Auswertelektronik des Stellelements 10 interpretiert eine streichende Bewegung eines Fingers 20 in eine zweite Richtung entlang der Oberfläche des Stellelements 10 als einen Wunsch des Benutzers, die eingestellte Lautstärke des Hörhilfegeräts zu reduzieren.

Die Auswertelektronik des Stellelements 10 kann dazu vorgesehen sein, weitere Bewegungsmuster eines Fingers 20 auf der Oberfläche des Stellelements 10 als weitere Benutzerwünsche zu erkennen und entsprechende Einstellungen des Hörhilfegeräts anzupassen. Das Stellelement 10 kann zweckmässigerweise punkt-, streifen- oder flächenförmig (als Matrix) ausgebildet sein.

Das Stellelement 10 kann beispielsweise eine Messung elektrischer Kapazitäten durchführen, um die Position des Fingers 20 auf der Oberfläche des Stellelements 10 zu ermitteln. Dazu kann das Stellelement 10 vertikal und horizontal in der Ebene angeordnete Elektroden aufweisen, die ein Gitter bilden. Die Auswertelektronik des Stellelements 10 führt fortlaufend Messungen der Kapazitäten dieser Elektroden durch. Ein in der Umgebung des Stellelements 10 befindlicher Finger 20 ändert die Kapazität der Elektroden. Aus dem Muster der Kapazitätsänderungen kann die Auswertelektronik des Stellelements 10 den Ort des Fingers 20 auf der Oberfläche des Stellelements 10 bestimmen. Aus dem Zeitverlauf der Kapazitätsänderungen kann eine Bewegung des Fingers 20 von der Auswertelektronik des Stellelements 10 erkannt werden.

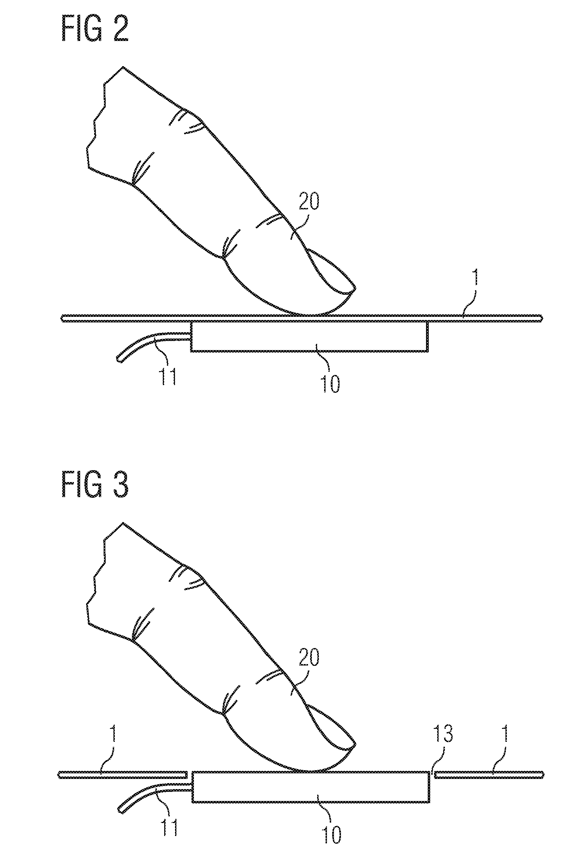

Wegen der kapazitiven Messmethode muss der Finger 20 das Stellelement 10 nicht unmittelbar berühren. Dies erlaubt es, das Stellelement 10 innerhalb des Gehäuses 1 des Hörhilfegeräts anzubringen, wie in Figur 2 dargestellt. Die Oberfläche des Stellelements 10 ist parallel zur Gehäuseoberfläche des Hörhilfegeräts angeordnet. Die Wand des Gehäuses 1 über dem Stellelement 10 ist so dünn, dass das Stellelement 10 die Position eines Fingers 20 detektieren kann, der das Gehäuse 1 von außen oberhalb des Stellelements 10 berührt. Die Wandstärke des Gehäuses 1 oberhalb des Stellelements 10 kann beispielsweise einen halben Millimeter betragen. Die Gehäusewand kann oberhalb des Stellelements 10 geringer sein als in anderen Abschnitten des Gehäuses 1.

Das Gehäuse 1 des Hörhilfegeräts ist zumindest im Bereich oberhalb des Stellelements 10 aus einem Material gefertigt, das eine kapazitive Beeinflussung des Stellelements 10 durch einen das Gehäuse von außen berührenden Finger 20 ermöglicht. Das Gehäuse 1 kann beispielsweise aus Kunststoff gefertigt sein. Die Gehäusewand kann oberhalb des Stellelements 10 aus anderem Material bestehen als in anderen Abschnitten des Gehäuses 1.
In einer anderen Ausführungsform des erfindungsgemäßen Hörhilfegeräts kann das Stellelement 10 die Position des Fingers 20 oder sonstigen Gegenstands in der Umgebung des Stellelements 10 durch Messung des reflektierten Signals eines ausgesandten Messsignals bestimmen. Dazu kann das Stellelement 10 beispielsweise ein elektromagnetisches Signal wie sichtbares Licht, eine Infrarot- oder Radiofrequenzstrahlung, oder ein Schall-, beispielsweise ein Ultraschallsignal aussenden. Aus der Phasenlage und/oder der Intensität des reflektierten Signals kann das Stellelement 10 die Position eines Fingers 20 oder sonstigen Gegenstands in der Umgebung des Hörhilfegeräts ermitteln.

In einer anderen Ausführungsform des erfindungsgemäßen Hörhilfegeräts kann das Stellelement 10 die Position des Fingers 20 oder sonstigen Gegenstands in der Umgebung des Stellelements 10 durch Messung einer durch den Finger 20 oder sonstigen Gegenstand ausgesandten Wärmestrahlung detektieren. Hierbei kann die Wand des Gehäuses 1 oberhalb des Stellelements 10 aus einem für Wärmestrahlung durchlässigen Material bestehen.

Da das Stellelement 10 innerhalb des Gehäuses 1 des Hörhilfegeräts angeordnet ist, kann das Gehäuse 1 vollständig geschlossen ausgebildet sein. Dadurch wird das Eindringen von Schmutz und Wasser in das Gehäuse 1 verhindert und die Störanfälligkeit des Hörhilfegeräts reduziert. In einer bevorzugten Ausführungsform kann das Gehäuse 1 des Hörhilfegeräts spritzwassergeschützt oder vollständig wasserdicht ausgebildet sein. Das Stellelement 10 weist keine beweglichen mechanischen Komponenten auf und ist daher unempfindlich gegenüber Abnutzungserscheinungen. Das geschlossene Gehäuse 1 des Hörhilfegeräts erlaubt eine attraktive und unauffällige Gestaltung des Hörhilfegeräts.

In Figur 3 ist eine alternative Ausführungsform eines erfindungsgemäßen Hörhilfegeräts schematisch dargestellt. In dieser Ausführungsform ist das Stellelement 10 in einer Ausnehmung 13 des Gehäuses 1 angeordnet. Dadurch ist die Oberfläche des Stellelements 10 von außen zugänglich. Vorzugsweise ist das Stellelement 10 bündig in die Ausnehmung 13 eingesetzt, sodass die Oberfläche des Stellelements 10 eine glatte Oberfläche mit der Wand des Gehäuses 1 bildet.

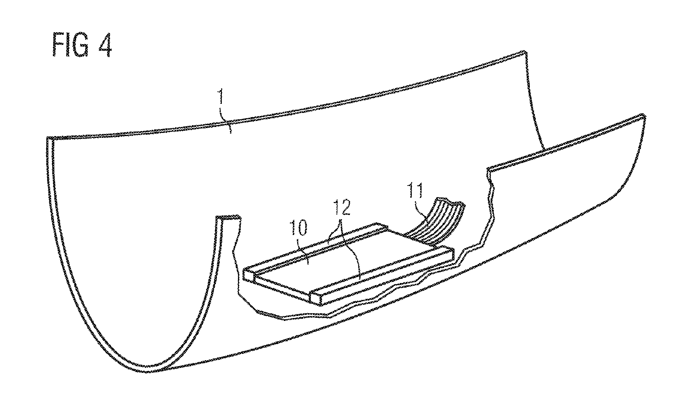

In Figur 4 ist eine weitere schematische Ansicht eines Ausschnitts eines Gehäuses 1 eines erfindungsgemäßen Hörhilfegeräts dargestellt. Gezeigt ist eine Innenansicht des Gehäuses 1. Ein Stellelement 10 ist wie in Figur 2 auf der Innenseite des Gehäuses 1 angeordnet. Das Stellelement 10 wird durch zwei Führungsschienen 12 an der Wand des Gehäuses 1 gehalten. Das Stellelement 10 ist über ein flexibles Kabel 11 mit einem Verstärker 3 des Hörhilfegeräts verbunden.

## Patentansprüche

1. Hörhilfegerät mit einem Gehäuse (1), darin angeordneten elektrischen Bauteilen (2, 3, 4, 5) und einem Stellelement (10), das vorgesehen ist, einen Einstellwert der elektrischen Bauteile (2, 3, 4, 5) zu verändern, **dadurch gekennzeichnet, dass** das Stellelement (10) als nichtmechanisches Bedienelement ausgeführt ist.

2. Hörhilfegerät nach Anspruch 1, **dadurch gekennzeichnet, dass** das Stellelement (10) berührungsfrei bedienbar ist.

3. Hörhilfegerät nach Anspruch 1 oder 2, **dadurch gekennzeichnet, dass** das Stellelement (10) einen Teil der Wand des Gehäuses (1) bildet.

4. Hörhilfegerät nach Anspruch 1 oer 2, **dadurch gekennzeichnet, dass** das Stellelement (10) innerhalb des Gehäuses (1) angeordnet ist.

5. Hörhilfegerät nach Anspruch 4, wobei die Wandstärke des Gehäuses (1) oberhalb des Stellelements (10) geringer ist als in anderen Gehäuseabschnitten.

6. Hörhilfegerät nach Anspruch 4 oder 5, **dadurch gekennzeichnet, dass** die Gehäusewand oberhalb des Stellelements (10) aus isolierendem Material besteht.

7. Hörhilfegerät nach einem der vorhergehenden Ansprüche, **dadurch gekennzeichnet, dass** das Stellelement (10) ausgelegt ist, durch Messung einer elektrischen Kapazität die Anwesenheit und/oder Position eines Gegenstands oder Fingers (20) in der Umgebung des Stellelements (10) zu detektieren.

8. Hörhilfegerät nach einem der vorhergehenden Ansprüche,
**dadurch gekennzeichnet, dass** das Stellelement (10) ausgelegt ist, durch Messung des reflektierten Signals eines ausgesandten Messsignals die Anwesenheit und/oder Position eines Gegenstands oder Fingers (20) in der Umgebung des Stellelements (10) zu detektieren.

9. Hörhilfegerät nach einem der vorhergehenden Ansprüche, **dadurch gekennzeichnet, dass** das Stellelement (10) ausgelegt ist, durch Messung einer Wärmestrahlung die Anwesenheit und/oder Position eines Gegenstands oder Fingers (20) in der Umgebung des Stellelements (10) zu detektieren.

10. Hörhilfegerät nach einem der vorhergehenden Ansprüche, **dadurch gekennzeichnet, dass** das Stellelement (10) einen Ein-/Ausschalter bildet.

11. Hörhilfegerät nach einem der vorhergehenden Ansprüche, **dadurch gekennzeichnet, dass** das Stellelement (10) ein Lautstärkestellglied bildet.

12. Hörhilfegerät nach einem der vorhergehenden Ansprüche, **dadurch gekennzeichnet, dass** das Stellelement ausgelegt ist, eine Mehrzahl von Bewegungsmustern des detektierten Fingers oder Gegenstands zu unterscheiden und jeweils zugeordnete Einstellwerte des Hörhilfegeräts zu verändern.

13. Hörhilfegerät nach einem der vorhergehenden Ansprüche, **dadurch gekennzeichnet, dass** das Stellelement (10) ein zweidimensionales Gitter von Elektroden aufweist.

14. Hörhilfegerät nach einem der vorhergehenden Ansprüche, **dadurch gekennzeichnet, dass** das Gehäuse (1) des Hörhilfegeräts vorgesehen ist, von einem Benutzer hinter einem Ohr getragen zu werden.

15. Hörhilfegerät nach einem der vorhergehenden Ansprüche, **dadurch gekennzeichnet, dass** das Gehäuse (1) des Hörhilfegeräts spritzwassergeschützt ausgebildet ist.

16. Hörhilfegerät nach einem der vorhergehenden Ansprüche, **dadurch gekennzeichnet, dass** das Gehäuse (1) des Hörhilfegeräts wasserdicht ausgebildet ist.
